# FASCICULE DE BREVET EUROPEEN

(11) **EP 2 138 451 B1**
(45) Date de publication et mention de la délivrance du brevet: **25.05.2011**
(21) Numéro de dépôt: 09290471.3
(22) Date de dépôt: 22.06.2009
(51) Int. Cl.: B81C 1/00, H03H 3/02

(54) **Procédé de fabrication d'un composant électromécanique MEMS/NEMS dans un matériau monocristallin**
Verfahren zur Herstellung eines elektromechanischen MEMS-Bauteils in einem einkristallinen Material
Method for manufacturing a MEMS/NEMS electromechanical component in a monocrystalline material

(30) Priorité: 23.06.2008 FR 0803494
(43) Date de publication de la demande: 30.12.2009
(73) Titulaire: Commissariat à l'Énergie Atomique et aux Énergies Alternatives, 75015 Paris (FR)
(72) Inventeur: Perruchot, François, 38000 Grenoble (FR); Diem, Bernard, 38130 Echirolles (FR); Larrey, Vincent, 38140 La Murette (FR); Clavelier, Laurent, 38000 Grenoble (FR); Defay, Emmanuel, 38340 Voreppe (FR)
(74) Mandataire: Rataboul, Xavier

(56) Documents cités:
- EP-A- 0 624 900
- EP-A- 1 905 734
- WO-A-2008/006641

## Description

La présente invention a pour objet un procédé de fabrication d'un composant micro-électromécanique de type MEMS/NEMS.

Les technologies dites de surface (par opposition aux technologies de volume) permettent de réduire la taille des structures électromécaniques (MEMS/NEMS) réalisées sur silicium. Ces technologies reposent sur l'utilisation d'un empilement d'au moins trois couches : la couche mécanique (typiquement de 0,1µm à 100µm), la couche sacrificielle (typiquement de 0,1µm à 5µm) et le support (typiquement de 10µm à 1000 µm), la gravure chimique sélective de la couche sacrificielle permettant de réaliser dans la couche mécanique des structures fonctionnelles localement indépendantes du support. Les zones non gravées de la couche sacrificielle permettent de réaliser des zones dites d'ancrage par lesquelles la structure mécanique est reliée au support. Par extension, il est possible de parler de réalisation de couches actives (couche mécanique comme cas particulier) sur une couche de découplage (couche sacrificielle comme cas particulier), la couche de découplage assurant la liaison entre le support et la couche active. Les structures de type BAW ("Bulk Acoustic Wave" - filtre ou résonateur à ondes acoustiques de volume) de type SMR (Solid Mounted Resonator) comportent par exemple un empilement piezoélectrique (couche active) sur un miroir de Bragg (couche de découplage) qui permet l'isolation acoustique entre la couche active et le support.

Si d'autres fonctions sont ajoutées entre le support et la couche active, comme par exemple des couches d'interconnexion, le terme plus général de couche d'interface (comprenant une couche de découplage) peut être employé.

Un procédé donné est en particulier caractérisé par le choix du couple couche mécanique (ou par extension couche active) - couche sacrificielle (ou par extension couche d'interface) et de la méthode permettant de les associer au support. Le choix d'un procédé se fait suivant des critères différents suivant le type de composant réalisé.

Par exemple pour une couche mécanique sur une couche sacrificielle, notamment silicium sur SiO₂, les principaux critères technologiques retenus pour disposer d'un procédé flexible apte à s'adapter à une large gamme de demande sont :
- la qualité de la couche mécanique, en premier lieu la stabilité de ses propriétés mécaniques mais aussi la précision sur son contrôle dimensionnel, en particulier sur son épaisseur,
- la possibilité de contrôler les dimensions latérales des zones d'ancrage par insertion dans la couche sacrificielle de zones non attaquées par la gravure chimique pour ne pas dépendre d'un contrôle par temps de gravure qui est sensible à la géométrie de la structure,
- la possibilité de disposer d'au moins un ou plusieurs niveaux d'interconnexion électrique au dessus ou/et en dessous de la couche mécanique, pouvant servir d'électrodes si nécessaires,
- la compatibilité avec l'ajout d'un capot silicium en particulier pour les structures inertielles,
- la possibilité de disposer d'épaisseurs distinctes de silicium sur le même composant.

La famille de procédés la plus utilisée repose sur le couple silicium (couche mécanique) sur silice (couche sacrificielle) associé à une gravure sélective de la silice par HF (liquide ou en phase vapeur). Cette famille fait partie des procédés MEMS SOI (pour Silicon on Insulator, c'est-à-dire silicium sur isolant).

Les procédés MEMS SOI les plus simples réalisent les deux couches SiO2/Si par dépôts successifs des matériaux, par exemple PECVD (dépôt chimique en phase vapeur assisté par plasma) ou LPCVD (dépôt chimique en phase vapeur à basse pression), sur un support en silicium (substrat silicium massif). Ces procédés sont avantageux car,
- le contrôle de l'épaisseur de la couche mécanique est obtenu par le temps de dépôt de la couche silicium,
- les zones d'ancrage sont très bien contrôlées puisque qu'il est possible d'utiliser directement la couche mécanique en gravant localement la couche d'oxyde avant le dépôt de silicium,
- il est possible de réaliser différents niveaux d'interconnexions.

Cependant, le silicium composant la couche mécanique déposé sur de l'oxyde est du silicium polycristallin ce qui rend plus difficile le contrôle de ses qualités mécaniques (contrôle du niveau des contraintes, stabilité, ...) et limite l'épaisseur pouvant être obtenue.

Des améliorations connues de ces procédés permettent d'utiliser comme couche mécanique du silicium monocristallin dont les propriétés mécaniques sont considérées comme supérieures avec une gamme d'épaisseurs accessibles plus importante.

Il est possible de citer trois grandes familles de procédés connus pour la réalisation d'un MEMS en silicium monocristallin par la technologie MEMS SOI (système électromécanique MEMS sur substrat de type silicium sur oxyde), familles qui se distinguent par la méthode retenue pour réaliser le substrat comportant l'empilement complet :
1) Le substrat de départ est un substrat SOI ayant une couche fine en Si de type microélectronique d'épaisseur contrôlée (typiquement de l'ordre de 100 nm), par exemple réalisé à partir de la technologie de clivage dite "Smart Cut" (marque déposée). La couche de SiO₂ qui sert d'isolation par rapport au substrat est utilisée comme couche sacrificielle et la couche de silicium fin sert de base à une épitaxie de silicium ce qui permet d'obtenir une couche mécanique en matériau monocristallin.
   Il est par ailleurs connu de réaliser des niveaux d'interconnexions au dessus d'une couche mécanique et des ancrages en SiN ou Si polycristallin comme dans l'article "Polysilicon Packaging and a new anchoring Technology for Thick SOI MEMS - Dynamic Response model and application to over-damped inertial sensors" de B. DIEM et collaborateurs (13th Int'l conference on Solid State Sensors Actuators and Microsensors Seoul, 5-9 June 2005, p. 527 - 530).
2) Le substrat de départ est un substrat de silicium comportant une couche d'oxyde. La couche mécanique est réalisée par collage d'un second substrat de silicium épais qui est ensuite aminci par rectification et polissage (cf Demande PCT WO 2006/035031). Avec ce procédé, la couche sacrificielle est utilisée comme couche d'adhésion et la qualité de collage est critique car il doit garantir que la gravure chimique sera homogène. L'implémentation de zones d'ancrage dans la couche sacrificielle avant collage est possible mais elle demande de maîtriser le collage de substrats avec des surfaces hétérogènes.
3) Le substrat de départ est un substrat de silicium épais sur lequel sont déposées la couche sacrificielle d'oxyde puis une multicouche de fonctionnalisation en SiN associé à du Si polycristallin et enfin une couche finale d'adhésion en Si polycristallin. Cet empilement initial est collé sur un second substrat de silicium servant de support. Le substrat épais de base est ensuite aminci par rectification et polissage pour réaliser la couche mécanique qui sert pour le système électromécanique (cf. l'article "Capacitive Accelerometer with high aspect ratio single crystallin silicon Microstructure using the SOI structure with polysilicon-based Interconnect Technique de T. YAMAMOTO et collaborateurs publié dans MEMS 2000, the thirteenth annual international conference, 23-27 janvier 2000, Miyazaki, Japan p. 514-519). Le procédé proposé permet de réaliser des zones d'ancrage en Si polycristallin, des couches d'interconnexion et des électrodes enterrées et la couche d'adhésion est distincte de la couche sacrificielle ce qui fait que la qualité du collage est moins critique, car il n'a alors que des fonctions mécaniques.

Pour un empilement piezoélectrique utilisé pour des structures de type BAW, c'est-à-dire à ondes acoustiques de volume, sur un miroir de Bragg, le critère de sélection de la filière peut être relié aux qualités physiques des matériaux utilisables.

Les deux exemples précédents, couche mécanique ou empilement piézoélectrique, montrent que la possibilité d'utiliser une couche active en matériau monocristallin peut être un facteur important dans le choix d'une filière.

Dans le cas de structures inertielles ou de structures à base de structure à ondes acoustiques de volume (BAW), il est nécessaire de réaliser un capot au dessus de la structure active à la fois pour la protéger mais aussi pour assurer le contrôle de l'atmosphère dans laquelle se trouve la structure (pression et composition). Ce capot ne doit pas ajouter de manière directe ou indirecte de contraintes au composant (en particulier lorsque le substrat de base est aminci pour diminuer l'épaisseur totale du dispositif).

Une première solution est de placer une structure MEMS découpée dans un boîtier. Cette technologie non collective augmente de manière significative le coût du composant et son volume total.

Les technologies connues pour réaliser de manière collective une protection au dessus d'une structure MEMS sont de deux types :
- soit par scellement d'une tranche de silicium comprenant des cavités au dessus des structures MEMS. C'est ce qui est par exemple proposé pour le procédé avec un scellement de type dit « glass-frit » et un passage de contact par-dessous la structure (comme par exemple dans le Brevet US 6 391 673)
- soit par réalisation d'un capot en couche mince. Par exemple il est possible pour le procédé 1 ci-dessus de réaliser un capot en Si polycristallin au dessus de la structure MEMS, comme par exemple dans l'article précité de B. DIEM.

Les solutions de report d'une tranche de silicium demandent d'utiliser un troisième substrat. La technologie de scellement nécessite une surface de collage suffisante pour assurer la tenue mécanique, ce qui augmente la surface totale du composant. De plus, il n'est pas possible de connecter électriquement le capot à la partie mécanique du composant. Or, des connexions électriques permettraient par exemple de contrôler le potentiel du capot et si nécessaire d'y inclure des électrodes.

Il existe des solutions pour reporter un capot en silicium en assurant une connexion électrique (référence AuSn sur composant : QIAN WANG et collaborateurs, Application of Au-Sn Eutectic Bonding in Hermetic Radio-Frequency Microelectromechanical System Wafer Level Packaging Journal of ELECTRONIC MATERIALS, Vol. 35, No. 3, 2006). Ces technologies ne sont pour l'instant maîtrisées au niveau industriel qu'à l'échelle du composant et de plus la connexion se fait à l'aide d'un alliage métallique dont la réalisation est complexe.

La solution associée au procédé 1 ci-dessus repose sur l'utilisation d'un dépôt en Si polycristallin et elle permet de transférer des contacts par le capot. Mais la nature du dépôt utilisé demande un contrôle de la contrainte qui est industriellement délicat. Ce contrôle est d'autant plus nécessaire si le support est aminci pour diminuer l'épaisseur totale du composant. De plus, l'épaisseur du capot est limitée à une dizaine de microns ce qui rend difficile l'utilisation de la face du capot pour des technologies d'intégration à trois dimensions.

Dans les procédés de type silicium sur isolant SOI utilisant une couche active monocristalline, il n'est actuellement pas possible de structurer cette couche mécanique dans la troisième dimension.

L'idée de base de l'invention est de s'affranchir au moins d'une des limitations de l'art antérieur en proposant un procédé utilisant un substrat hétérogène en un ou plusieurs matériaux monocristallins comprenant une ou plusieurs zones pouvant être sélectivement gravées par rapport à ces matériaux monocristallin, ce qui permet notamment de disposer *in fine* d'une ou plusieurs cavités permettant de réaliser une structure tri-dimensionnelle dans la couche active.

Ceci permet par exemple de réaliser un capot en silicium monocristallin pour les structures inertielles ou les structures de type BAW mais aussi d'intégrer dans le même dispositif des éléments mécaniques de différentes épaisseurs, soit l'un à coté de l'autre, par exemple pour réaliser des capteurs de sensibilités différentes sur le même composant, soit l'une sur l'autre ou de réaliser des électrodes au dessus de la couche mécanique.

Il est également possible pour des structures de type BAW d'utiliser certains matériaux en couche mince sous forme monocristalline pour obtenir, y compris à faible épaisseur, des propriétés physiques proches des propriétés du monocristal massique ou au moins supérieures à celles obtenues avec des films amorphes ou polycristallins réalisés notamment par dépôt ou sol-gel. C'est le cas par exemple du PZT (titano zirconate de plomb) qui peut être réalisé par épitaxie à partir d'une couche de transition sur du silicium monocristallin (voir l'article Epitaxial growth of Pb(Zr0.2Ti0.8)O3 on Si and its nanoscale piezoelectric properties, A. Lin et collaborateurs, Applied Physics Letters, volume 78-14 du 2 avril 2001). C'est également le cas du PMNT.

La Demande PCT WO 2008/006641 décrit un procédé de fabrication d'une structure électromécanique comprenant au moins un élément actif susceptible d'être en vibration entre deux cavités. L'épaisseur de ces cavités est déterminée par l'épaisseur de dépôt d'une couche unique en SiGe monocristalline. Il ne permet donc pas de réaliser au sein du même substrat des cavités de hauteurs différentes.

L'invention concerne ainsi un procédé de fabrication d'un dispositif électromécanique comprenant au moins un élément actif tel que défini dans la revendication 1.

Le procédé selon l'invention permet de réaliser des couches enterrées monocristallines dans un substrat hétérogène monocristallin.

On notera que l'article "Local buried oxide technology for HV transistors integrated in CMOS" de E. SAARNILEHTO et collaborateurs, paru dans Proceedings of the 19th International Symposium on Power Semiconductor Devices & ICs, May 27-30, 2007 Jeju, Korea p. 81 à 84, prévoit de réaliser des épitaxies successives de Si et de SiGe pour réaliser des couches enterrées en SiGe, mais cela ne permet pas de former une cavité enterrée dont la largeur et l'épaisseur peuvent être choisies à volonté au sein d'un substrat monocristallin car seule la couche de SiGe est gravée chimiquement pour réaliser la cavité. L'épaisseur de la cavité est donc limitée à l'épaisseur de SiGe et sa largeur est limitée par la sélectivité de la gravure de SiGe avec arrêt sur Si. D'autre part, les Demandes de Brevet FR 2 876 219 et FR 2 876 220 permettent de réaliser des régions enterrées en SiO₂, mais il nécessite un collage d'un substrat en Si.

Les zones localisées peuvent être des tranchées ou bien être pleines et gravées après l'étape c de manière à former des tranchées, par exemple par gravure sélective avec arrêt sur Si.

Le procédé peut être caractérisé en ce que les zones localisées sont pleines, en ce que la couche d'interface comporte une couche sacrificielle en contact avec la deuxième région, en ce qu'il comporte la réalisation d'au moins une ouverture débouchant sur ladite couche sacrificielle qui est réalisée à partir de la surface de la première partie en dehors de la ou des zones enterrées, jusqu'à atteindre la couche sacrificielle, l'enlèvement au moins partiel de la couche sacrificielle par gravure à travers au moins une dite ouverture et la gravure des zones localisées de manière à former des tranchées.

Le procédé peut être caractérisé en ce que la couche d'interface comprend une couche sacrificielle en contact avec la deuxième région, et en ce qu'il comporte après l'étape c) une étape d'enlèvement au moins partiel de ladite couche sacrificielle au moins au voisinage d'un dit élément actif.

La couche sacrificielle peut être ensuite enlevée au moins partiellement par gravure à travers lesdites ouvertures ménagées lors de l'étape c, au moins une dite cavité et des tranchées ménagées dans ladite deuxième région, qui peuvent être ou non les tranchées des zones localisées.

Préalablement audit enlèvement de la couche sacrificielle, au moins une ouverture débouchant sur ladite couche sacrificielle peut être réalisée dans la première partie en dehors de la ou des zones enterrées.

Le procédé peut alors être caractérisé en ce que la réalisation de la première partie du substrat hétérogène comporte à partir d'un support en ledit premier matériau monocristallin :
a₀) la formation d'au moins une zone enterrée par :
   - épitaxie sur ledit support, d'une première couche de SiGe monocristallin,
   - épitaxie d'une couche de Si monocristallin,
   - épitaxie d'une deuxième couche de SiGe monocristallin, et
a₁) l'épitaxie d'au moins une couche de matériau monocristallin, au moins sur la deuxième couche épitaxiée de SiGe pour former au moins une partie de l'élément actif
ou bien en ce que la réalisation de la première partie du substrat hétérogène comporte à partir d'un support en silicium monocristallin:
a'0) la formation d'au moins une zone enterrée par réalisation de silicium poreux dans au moins une partie dudit support et
a'1) l'épitaxie d'au moins une couche de matériau monocristallin, au moins sur le silicium poreux pour former au moins une partie de l'élément actif.

La couche sacrificielle peut être en PSG ou en silice.

La couche d'interface peut comporter des connexions électriques du dispositif électromécanique.

Selon une première variante, le substrat comporte au moins deux zones enterrées d'épaisseurs égales juxtaposées.

Selon une deuxième variante, le substrat comporte au moins deux zones enterrées d'épaisseurs différentes juxtaposées.

Selon une troisième variante, le substrat comporte au moins deux zones enterrées au moins partiellement superposées.

Dans le cas où substrat comporte des épaisseurs de zones enterrées différentes, le procédé peut comporter plusieurs dépôts successifs de SiGe et Si.

Dans un premier mode de réalisation, les zones de gravure enterrées sont réalisées en utilisant du silicium poreux, matériau connu comme couche sacrificielle (voir article de P Steiner, A Richter and W Lang, « Using porous silicon as a sacrificial layer », J. Micromech. Microeng. 3 (1993) 3236). Les zones de Si poreux peuvent être localisées en utilisant les techniques de masquage connues.

Par extension, le silicium poreux est dans le cadre de la présente invention considéré comme un matériau monocristallin en raison du fait qu'il conserve un réseau cristallin suffisant pour permettre l'épitaxie d'un autre matériau monocristallin tel que le silicium.

Dans un second mode de réalisation, les zones de gravure enterrées sont réalisées en utilisant un ensemble de trois couches de SiGe, Si et SiGe.

Dans un mode de réalisation avantageux, le substrat hétérogène est réalisé par collage de deux substrats dont au moins le premier est hétérogène et comporte les zones de gravure.

La réalisation de ce premier substrat peut donc comporter la réalisation des zones de gravure dans un substrat silicium hétérogène comme indique ci-dessus, puis l'épitaxie d'une couche active en matériau monocristallin, la réalisation des tranchées par gravure du silicium de la couche mécanique sous la ou les cavités.

Le procédé de réalisation du substrat hétérogène peut se poursuivre :
- soit par le remplissage ou la fermeture des tranchées (régions pleines ou vides) du premier substrat lorsqu'elles sont présentes par un matériau sacrificiel différent du Si au sens d'une gravure chimique (possibilité de gravure sélective), lequel forme également une couche recouvrant la surface de la deuxième couche épitaxiée en Si monocristallin, la couche sacrificielle étant ensuite planarisée si nécessaire suivi du collage d'un deuxième substrat sur ladite couche sacrificielle.
- soit par le collage d'un deuxième substrat comportant une couche sacrificielle, le collage s'effectuant directement sur les tranchées.

Le procédé peut comporter ensuite :
- la réalisation à travers la couche en Si monocristallin du premier substrat, d'au moins une ouverture s'étendant au moins jusqu'à une première zone de gravure en Si poreux (premier mode) ou jusqu'à une première zone de gravure en SiGe monocristallin, et de préférence jusqu'à la première couche épitaxiée en Si monocristallin (second mode),
- optionnellement la réalisation ou le dépôt d'une couche en un matériau protecteur sur les parois d'au moins une ouverture pour le deuxième mode,
- l'enlèvement sélectif à travers la ou les ouvertures d'au moins une partie du Si poreux (premier mode) ou de la région de la première couche épitaxiée en Si monocristallin qui est située entre une première région en SiGe monocristallin et la deuxième couche en SiGe monocristallin (deuxième mode) pour former au moins une cavité.

Le procédé peut alors comporter:
- une gravure de la ou des ouverture(s) remplies du matériau sacrificiel et d'une partie de la couche sacrificielle pour libérer un système électomécanique MEMS dans la deuxième couche en Si monocristallin lorsque qu'il existe des tranchées ou la réalisation d'ouverture spécifiques pour la gravure d'une partie de la couche sacrificielle. La réalisation de ces ouvertures peut être simultanée à la réalisation des ouvertures associées aux zones de gravure.

Au cours de l'étape d'enlèvement sélectif, le procédé peut mettre en oeuvre la réalisation de deux ou plusieurs cavités d'épaisseurs égales ou non disposées côte à côte. Ces cavités peuvent être réalisées pour réaliser la base d'un capot intégré, deux épaisseurs de couche mécanique sur le même dispositif ou deux épaisseurs l'une sur l'autre ou des électrodes au dessus de la couche mécanique.

Au cours de la réalisation de la couche en Si monocristallin du premier substrat d'au moins une ouverture, il peut être réalisé au moins une dite ouverture traversant la couche en Si monocristallin du premier substrat et la première couche épitaxiée en Si monocristallin et s'étendant jusqu'à la couche sacrificielle. Cette variante peut être mise en oeuvre quelque soit le nombre de cavités réalisées dans le substrat composite.

D'autres caractéristiques et avantages de l'invention apparaîtront mieux à la lecture de la description qui va suivre, donnée à titre d'exemple non limitatif, en liaison avec les dessins dans lesquels :
- les figures 1a à 1o illustrent un procédé de réalisation préféré d'un système électro-mécanique MEMS selon un premier mode de réalisation de l'invention, dont une variante est illustrée par les figures 1h', 1i' et 1o', et une autre variante par la figure 1j".
- les figures 2a à 2f illustrent un procédé de réalisation d'un système électromécanique selon un deuxième mode de réalisation de l'invention, avec du Si poreux.
- les figures 3a à 3b illustrent la réalisation d'un résonateur piézo-électrique à ondes acoustique de volume.
- et les figures 4 à 9 illustrent la fabrication de 6 structures I à VI, à savoir I (figures 4a à 4c), II (figures 5a et 5b), III (figures 6a et 6b), IV (figures 7a et 7b), V (figures 8a et 8b), et enfin VI (figures 9a à 9c).

Le procédé proposé repose sur la réalisation d'une première partie d'un substrat hétérogène, première partie comportant une ou plusieurs zones de gravure enterrées pouvant être sélectivement gravées par rapport au silicium pour réaliser des cavités.

Dans un premier exemple de mise en oeuvre, les zones de gravure dans le premier substrat sont réalisées par un multicouche SiGe, Si, SiGe. Ce mode de mise en oeuvre repose sur la possibilité connue de graver sélectivement le SiGe avec arrêt sur Si ou le Si avec arrêt sur SiGe.

La sélectivité SiGe sur Si est faible dans tous les cas connus mais suffisante pour être utilisée en attaque frontale pour enlever des couches de SiGe sur Si. En attaque latérale (libération d'une cavité), cette sélectivité permet de réaliser des structures mais avec des faibles facteurs de forme.

La sélectivité Si sur SiGe peut être très importante Cette propriété permet de réaliser des cavités avec de forts facteurs de forme avec gravure de Si par arrêt sur SiGe.

(cf. publication S. Borel et collaborateurs, Control of Selectivity between SiGe ans Si in isotropic Etching processes, Japanese Journal of Applied Physics, vol. 43, N° 6B, 2004, PP 3964-3966)

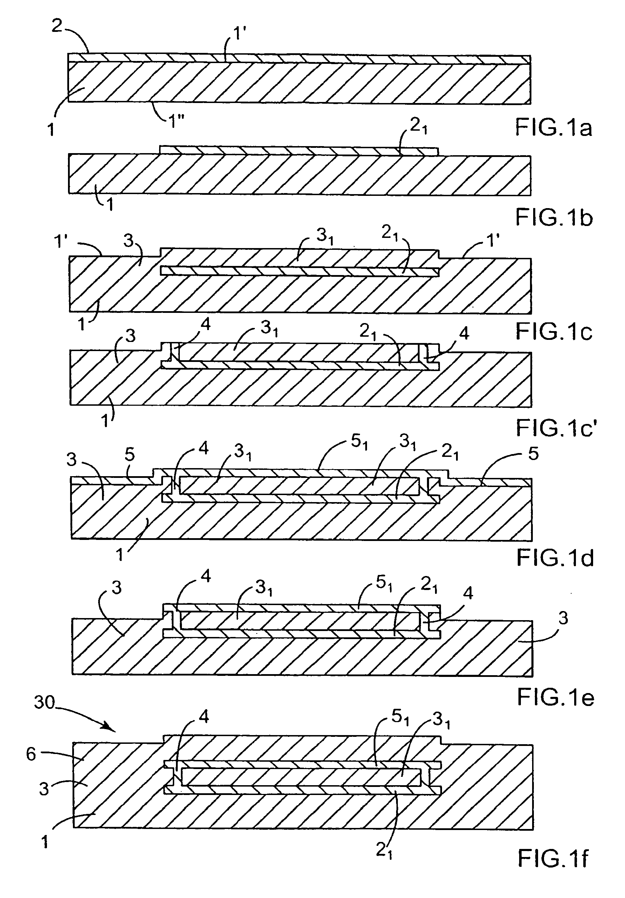

Une couche 2 de SiGe monocristallin d'épaisseur par exemple entre 10 nm et 300 nm, typiquement 100 nm, et ayant une concentration molaire en Ge comprise entre 20 % et 60 %, est épitaxiée sur une surface d'un substrat ayant une couche 1 en Si monocristallin (figure 1a).

La couche 2 de SiGe est gravée localement pour donner une ou plusieurs zones 2₁ (figure 1b).

Le choix de l'épaisseur de la couche 2 de SiGe et de la concentration en Ge permet d'épitaxier sur la surface restante 1' de la couche 1 et sur la ou les zones 2₁ (figure 1c) une couche de Si monocristallin 3 ayant une ou plusieurs régions monocristallines 3₁, avec une qualité suffisante pour que la couche mécanique 6 d'un MEMS qui sera ultérieurement épitaxiée ait des propriétés satisfaisantes.

La figure 1c' montre une étape optionnelle de gravure dans une région 3₁ épitaxiée sur une région 2₁ d'une ou plusieurs tranchées 4 destinées à réaliser des arrêts de gravure latéraux. Ces tranchées 4 peuvent ne s'étendre que jusqu'à la zone 2₁ en SiGe, mais il est préférable qu'elles traversent cette zone 2₁. Pour des structures relativement simples, il est possible de se dispenser de ces tranchées 4, la gravure s'effectuant alors avec arrêt au bout d'un temps donné adapté à la largeur souhaitée de la gravure latérale.

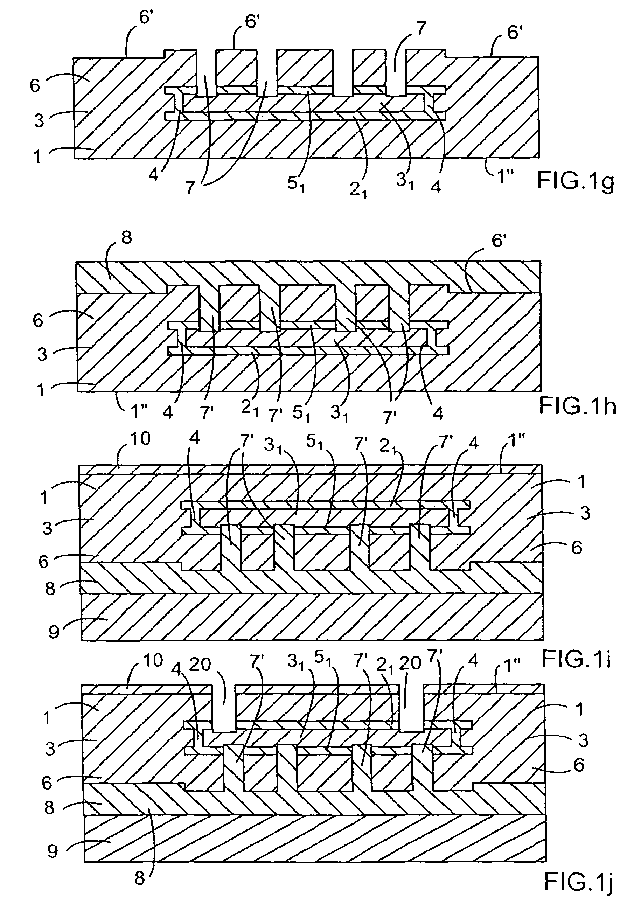

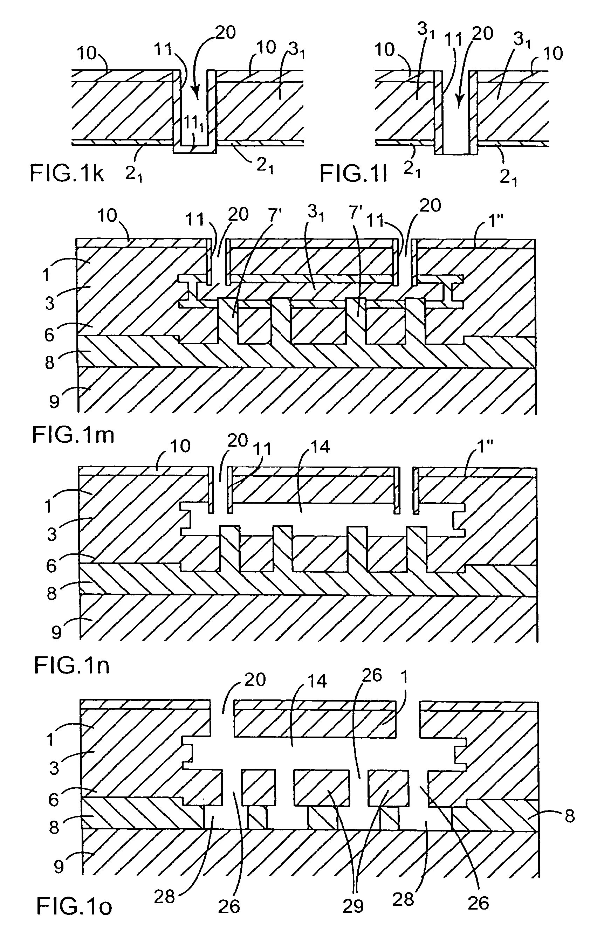

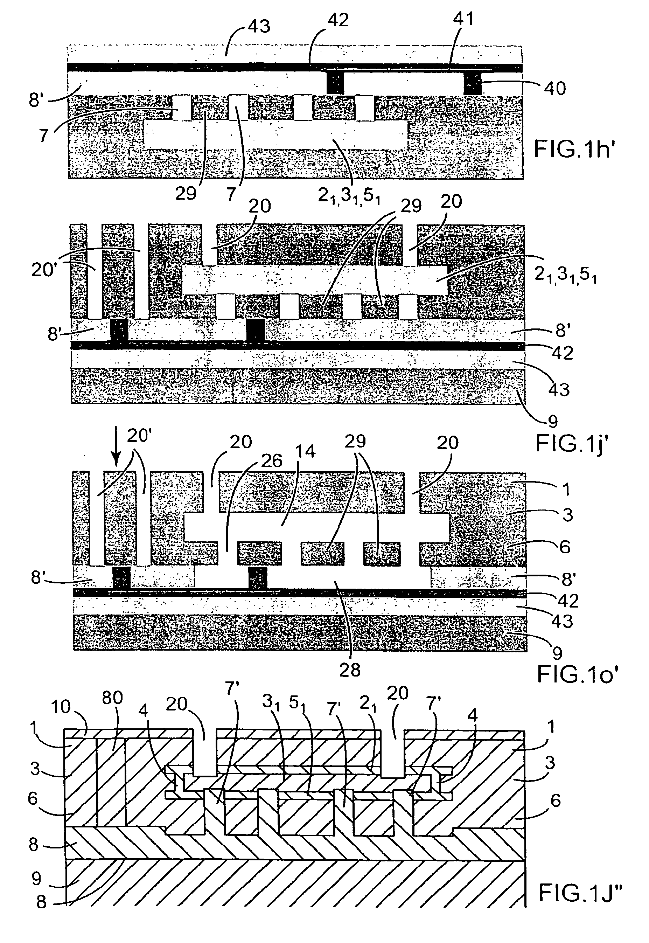

Une deuxième couche 5 de SiGe monocristallin est ensuite déposée sur la surface (figure 1d) et elle peut être ensuite gravée pour former (comme représenté) une ou plusieurs zones 5₁, de préférence de même contour que la ou les zones 2₁ (figure 1 c).

Cette opération est suivie d'un dépôt par épitaxie d'une couche 6 de Si qui est ensuite planarisée si les couches de SiGe ne couvrent pas la totalité de la surface par exemple par par planarisation chimico-mécanique CMP (figure 1f), ce qui donne un substrat monocristallin composite 30 contenant une ou plusieurs zones 3₁ en Si monocristallin qui sont en sandwich entre deux zones 2₁ et 5₁ en SiGe monocristallin, ces zones étant elle-mêmes incluses dans un substrat épitaxié 1, 3, 6 en Si monocristallin.

Dans cet exemple, la première partie comprend un premier substrat 30 en silicium monocristallin qui comporte une zone de silicium délimitée par deux plans parallèles de SiGe typiquement de 100 nm (voir ci-dessous). Les deux plans parallèles de SiGe permettent d'utiliser cette zone de silicium comme couche sacrificielle (couche sacrificielle Si dans du Si) car il est possible de graver sélectivement le Si en s'arrêtant sur le SiGe avec une très bonne sélectivité. Les zones de gravures sont définies dans ce cas à partir des zones 2₁ et 5₁ et comprennent également le silicium se trouvant entrent ces zones.

Les étapes des figures 1g à 1k détaillent la réalisation d'un système MEMS à partir du premier substrat 30, dont l'une et/ou l'autre des couches 1 et 6 peut être utilisée comme couche mécanique pour un système électro-mécanique MEMS.

La figure 1g illustre la réalisation dans la couche 6 de tranchées 7 qui servent à définir la géométrie du ou des éléments actifs par exemple par gravure par le procédé DRIE (deep reactive ion etching ou gravure ionique réactive profonde) à travers la couche épitaxiée 6 en Si avec arrêt après une couche 5₁ en SiGe.

La figure 1h illustre le dépôt d'une couche sacrificielle 8 par exemple en SiO₂ qui remplit les tranchées 7 et qui recouvre la surface 6' de la couche épitaxiée 6. Les tranchées remplies portent la référence 7' et sont des zones localisées qui relient les zones enterrées à la couche sacrificielle. Ces zones localisées sont appelées à être ultérieurement gravées sélectivement pour redevenir des tranchées. Ces tranchées localisées définissent la géométrie d'au moins un élément actif. La couche sacrificielle 8 peut être planarisée par exemple par planarisation chimico-mécanique CMP. Elle sert par exemple de couche sacrificielle pour libérer le système MEMS défini par les tranchées 7.

Il est également possible notamment lorsque l'épaisseur et la dimension des tranchées ne se prêtent pas au remplissage (forte épaisseur et larges tranchées), d'utiliser une couche 8' couvrant les tranchées 7 sans les remplir par exemple en utilisant du verre phospho-silicate PSG. Cette variante est illustrée à la figure 1 h' et la suite de cette variante par les figures 1j' et 1o'. Ce dépôt 8' peut également servir de couche sacrificielle pour libérer les régions 29 constituant le système MEMS et il n'est pas nécessaire de le planariser. Il est également possible d'utiliser les techniques connues de fonctionnalisation de la couche sacrificielle (article précité de YAMAMOTO) en particulier pour réaliser une couche d'adhésion sur le premier substrat distinct de la couche sacrificielle.

Cette fonctionnalisation permet également de réaliser des contacts électriques vers la couche mécanique 6 à travers la couche sacrificielle associés à un réseau d'interconnexion placé sous la couche sacrificielle. On peut donc réaliser des tranchées dans la couche sacrificielle qui sont ensuite remplies par du silicium polycristallin dopé 40 servant également à réaliser des pistes d'interconnexion 41. L'ensemble est ensuite recouvert par une couche de nitrure 42 puis par une couche d'adhésion 43 en Si polycristallin on en oxyde pour coller un deuxième substrat. Il est également possible de réaliser des arrêts de gravure.

Dans l'un ou l'autre cas (1 h ou 1 h') un deuxième substrat 9 en Si est ensuite collé, par exemple par collage moléculaire, sur la couche 8 ou sur la couche 43 et le substrat est retourné (figure 1 i) permettant d'obtenir le substrat hétérogène.

Il est également possible de ne pas réaliser de dépôt de couche sacrificielle sur le premier substrat et de coller après la réalisation des tranchées un deuxième substrat comportant déjà une couche sacrificielle. Cette couche sacrificielle peut dans ce cas avoir été localement gravée, le collage se faisant alors avec des cavités se faisant face. Dans ce cas, la couche d'interface comprend une couche sacrificielle déjà gravée. La couche sacrificielle peut également être partiellement réalisée sur les premier et deuxième substrats et servir de couche d'adhésion.

La couche 1 est éventuellement amincie à une épaisseur dépendant de la fonction réalisée par la couche mécanique pour le système MEMS et également pour limiter le temps de gravure ultérieur des trous.

Des ouvertures sont gravées par exemple par procédé DRIE dans la couche 1 dans des zones ne comportant pas de SiGe, par exemple en périphérie du composant et traversent toute l'épaisseur de silicium en s'arrêtant sur l'oxyde. Ces ouvertures permettent de créer des piliers de silicium électriquement isolés du reste de la couche mécanique. Ces piliers peuvent être utilisés pour remonter différentes connexions électriques vers le haut du composant comme illustré sur la figure.

Une couche d'oxyde 10 est déposée ou obtenue par oxydation thermique du silicium. Puis un film sec est déposé pour servir de masque lors des opérations suivantes de gravure. Les opérations de lithographie sur film sec ne permettant pas d'obtenir les résolutions les plus élevées, il est possible d'inverser l'ordre des gravures DRIE en fonction du besoin en gravure plus fine (contacts ou ouvertures).

La figure 1j illustre la réalisation d'ouvertures 20 qui sont gravés dans la couche 1 à partir de la surface 1" par exemple par le procédé DRIE et traversent une ou plusieurs zones 2₁ en SiGe.

La figure 1j' prévoit également la réalisation d'ouvertures 20' situées en dehors de la ou des zones enterrées (2₁, 3₁, 5₁) et qui s'étendent jusqu'à la couche sacrificielle 8'.

Le bord et le fond des ouvertures 20 sont oxydés (figure 1k) pour former une couche d'oxyde de protection 11, 11₁ pour permettre la gravure ultérieure des couches 2₁, 3, et 5₁ (figure 1j) de manière à former au moins une cavité 14.

La couche d'oxyde est gravée au fond des ouvertures. La figure 1l montre le substrat après gravure de la couche d'oxyde 11₁ au fond des ouvertures.

La figure 1m illustre la gravure sélective (par gravure chimique humide ou par gravure ionique réactive RIE) de la couche de silicium 3₁ à travers les ouvertures de libération 20 pour former une cavité 14. Cette gravure s'arrête sur les couches 2₁ et 5₁ en SiGe et éventuellement sur les régions 4 d'arrêt de gravure latérale. En l'absence des tranchées 4 d'arrêt de gravure latérale, la géométrie de la cavité 14 peut être définie par la disposition spatiale des trous 20 et le temps de gravure.

La figure 1n illustre la gravure sélective (par gravure RIE, cf document S. Borel) des couches 2₁, 5₁ en SiGe avec arrêt de gravure sur le silicium.

La libération du système MEMS peut être réalisée (figure 1o) par gravure de l'oxyde bordant les trous 20, des tranchées remplies 7' et de la couche sacrificielle 8 pour donner des tranchées décapées 26 et ou une plusieurs régions décapées 28 de la couche sacrificielle 8 ou 8' libérant des régions actives 29 de la couche mécanique 6.

La variante de la figure 1h' conduit par exemple à la figure 1o' en passant par la figure 1j' (les autres figures n'ont pas été représentées). Dans ce cas, le décapage de la couche sacrificielle 8' s'effectue après gravure de la ou des cavités 14 à travers les tranchées 7 conservées.

Les figures 1a à 1o décrivent le cas où la zone de gravure est complètement définie par les parois en SiGe. Dans une variante de réalisation, il est également possible de ne pas graver les couches 2 et 5 de SiGe afin qu'elles recouvrent tout le substrat et de se passer des arrêts de gravure latéraux. Dans ce cas, où la couche enterrée s'étend jusqu'au bord de la première partie du substrat hétérogène, la ou les cavités sont définies par les deux plans parallèles de SiGe et la position des trous 20 par attaque isotrope du silicium à partir des trous. Cette variante permet d'éviter les étapes de gravure sélective des couches de SiGe et de réalisation des arrêts de gravure. Elle évite également de définir *a priori* la dimension et la position de la ou des cavités. L'étape optionnelle de planarisation de la dernière couche épitaxiée de silicium est également supprimée. Ce mode est donc plus simple et moins coûteux; en contre-partie, la géométrie est moins précisément définie mais cela est suffisant lorsque la géométrie demandée pour les cavités est simple. C'est le cas par exemple de la réalisation de capot intégrés.

On obtient ainsi un système MEMS inclus dans un substrat en Si monocristallin dont la couche 1 sert de capot. Elle peut être recouverte d'une couche de verre phosphosilicate PSG recouvrant au moins les tranchées 11.

Cette couche 1 peut également servir à réaliser des électrodes au dessus de la couche mécanique. Les ouvertures réalisées servent alors à la fois d'accès aux zones pour réaliser des cavités mais également de structuration des électrodes. Ces électrodes doivent électriquement être isolées du reste de la couche mécanique (voir schéma sur géométrie des cavités et fonctions associées). Les contacts électriques vers la partie mécanique peuvent être accessibles à partir de piliers en silicium se trouvant en dehors de la zone du capot ou des électrodes reliés à certaines parties de la couche mécanique à travers des pistes et piliers en silicium polycristallin dopé sous ou à travers la couche sacrificielle.

La couche sacrificielle 8 peut être mise à profit pour réaliser des prises de contact en réalisant des dépôts localisés d'un matériau conducteur par exemple du Si polycristallin dans les tranchées 7 entre les étapes des figures 1g et 1h et/ou bien encore pour réaliser par gravure et dépôt des piliers de renforcement par exemple en nitrure de Si. D'autres tranchées peuvent être ménagées pour réaliser des prises de contact.

La couche sacrificielle 8 peut également recevoir des plages conductrices par exemple en Si polycristallin pour réaliser des interconnexions.

La figure 1j" illustre le cas où au moins une ouverture 80 est ménagée à travers les couches 1, 3 et 6 en dehors de la ou des zones enterrées jusqu'à atteindre la couche sacrificielle 8. Il est de la sorte possible d'enlever sélectivement au moins une partie de la couche sacrificielle 8 et ensuite de graver les zones localisées 7' pour réaliser les tranchées décapées 26.

Dans le deuxième mode de réalisation du procédé, au moins une zone de gravure dans le premier substrat est réalisée en silicium poreux.

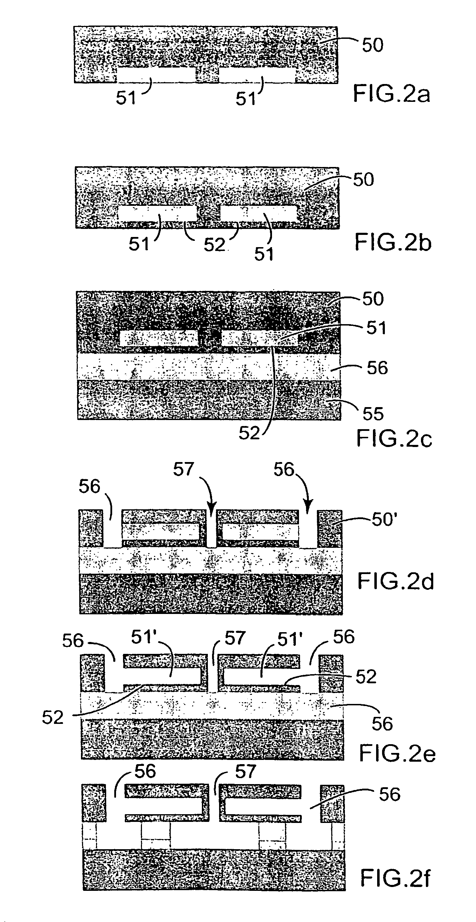

Le premier substrat composite est réalisé à partir d'un substrat Si 50 dans lequel sont réalisées après masquage une ou plusieurs zones de gravure 51 en Si poreux (figure 2a) à partir d'une technique de dissolution électrochimique du Si dans le HF (voir par exemple l'article « using porous silicon as sacrificial layer » par P Steiner, J. Micromech. Microeng. 3 (1993) 3236). Une épitaxie d'une couche de silicium monocristallin est ensuite réalisée (figure 2b). Si des cavités d'épaisseurs différentes doivent être réalisées, l'opération peut être répétée : réalisation d'une nouvelle zone de gravure superposée à une zone de gravure 51 après masquage puis deuxième épitaxie de Si.

Des tranchées peuvent être réalisées dans la dernière couche Si qui a été réalisée (52 ou couche supplémentaire dans le cas de cavités d'épaisseurs différentes) qui fait office de couche mécanique. Ces tranchées réalisées par attaque DRIE débouchent dans une ou plusieurs zones 51 en Si poreux destinées à former des cavités obtenues par gravure sélective des zones 51.

Un deuxième substrat 55 comportant une couche 56 oxydée en surface est ensuite collé sur le premier substrat par une méthode de collage de type moléculaire connue (figure 2c).

Des ouvertures sont ensuite réalisées dans la couche supérieure 50 de Si du premier substrat après si nécessaire amincissement 50'de cette couche à la fois pour la gravure de la zone de gravure (ouvertures 56) et la gravure de la couche sacrificielle (ouvertures 57) (figure 2d). Une gravure du Si poreux des zones de gravure 51 pour former des cavités 51' avec arrêt sur Si est réalisée, par exemple à partir d'une solution de KOH de faible concentration, typiquement 1%. La géométrie des cavités est déterminée par la combinaison de la position des tranchées de libération 56 et des zones 51 en Si poreux (figure 2e).

Finalement la couche mécanique est libérée par gravure 51 de la couche sacrificielle à travers les ouvertures 56 et 57 (figure 2f).

Il est également possible de remplacer les zones de gravure en Si poreux par des zones en silicium fortement dopé mais la sélectivité obtenue est moins bonne.

Il est également possible d'utiliser le procédé tel que décrit pour réaliser des cavités au dessus d'autres matériaux monocristallins afin d'obtenir des propriétés physiques, y compris à faible épaisseur, proches des propriétés du monocristal massique ou du moins supérieures à celles obtenues pour le même matériau obtenu dans une phase amorphe ou polycristalline. Dans la famille des perovskytes, c'est le cas par exemple du PZT (titano-zirconate de plomb) qui peut être réalisé par épitaxie à partir d'une couche de transition monocristalline en SrTiO3 (perovskite STO) sur du silicium monocristallin avec des propriétés piezoélectriques potentiellement supérieures, à celles des films amorphes ou polycristallin réalisés notamment par dépôt par un procédé sol-gel (article cité précédemment de A. Lin et collaborateurs). Pour utiliser ce matériau pour réaliser par exemple une détection piezoélectrique, il est possible de réaliser une électrode sous la couche de PZT en utilisant du SrRuO3 également monocristallin. Il est également possible d'utiliser la même approche en remplaçant le PZT par du PMNT (titanate de plomb magnésium niobium).

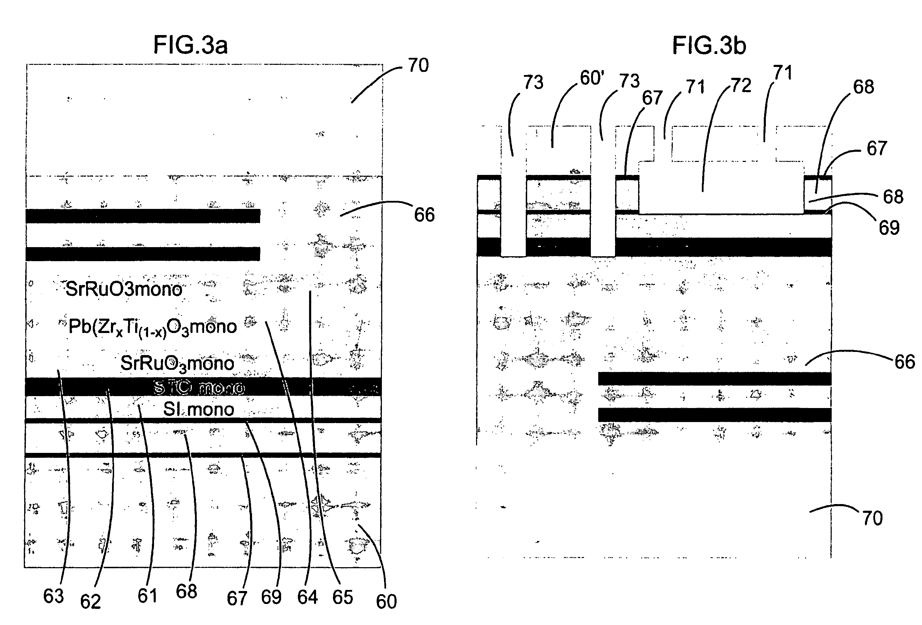

Cette possibilité est illustrée par un exemple de mise en oeuvre de l'invention pour la réalisation d'un résonateur piézoélectrique à ondes acoustiques de volume (BAW) avec un capot intégré illustré par les figures 3a et 3b.

La zone enterrée composée d'un empilement de SiGe 67, Si 68 et SiGe 69 est réalisé comme dans le premier exemple sur un substrat 60 en silicium monocristallin. Une couche de transition composée d'une couche de silicium monocristallin 61 et d'une couche monocristalline de perovskite STO 62 est réalisée par épitaxie (STO correspond à SrTiO₃). L'empilement piezoélectrique est composé d'électrodes 63 et 65 en SrRuO3 monocristallin associées à une couche piézoélectrique 64 de PZT monocristallin selon un procédé connu (article cité précédemment de A. Lin et collaborateurs). Les gravures locales de la première électrode et de la couche de PZT permettent d'utiliser la première couche 63 de SrRuO3 à la fois pour la première électrode et pour réaliser une connexion électrique vers la deuxième électrode 65. Un miroir de Bragg 66 est ensuite réalisé au dessus de la partie du résonateur qui est ensuite libérée suivant un procédé connu par dépôt d'un multicouche de SiO₂ (par PECVD) et de W (par pulvérisation). Chaque dépôt de SiO₂ est suivi d'une planarisation chimico-mécanique CMP pour obtenir une structure plane. Les différentes épaisseurs sont définies par la fréquence de résonance du résonateur. La dernière couche de SiO₂ peut également servir de couche d'adhésion à un deuxième substrat 70, de préférence oxydé et jouant le rôle de support (figure 3a).

Le substrat hétérogène réalisé est ensuite retourné et le premier substrat 60 est aminci 61' par rectification jusqu'à une épaisseur typiquement de 100 µm (figure 3b). Des ouvertures sont réalisées par DRIE et la cavité 72 est obtenue par gravure de SiGe 67, Si 68 et SiGe 69 en arrêtant la gravure latéralement. Les ouvertures 71 sont en final scellées sous vide à partir d'une couche de PSG. Les contacts vers les électrodes peuvent être pris à travers des tranchées 73 réalisées dans les couches SiGe et Si par DRIE, le fond 62 en STO étant enlevé par une gravure HF vapeur rapide (figure 3b), pour atteindre l'électrode 63 en SrRuO3.

Le composant ainsi obtenu est un résonateur BAW de type SMR (Solid Mounted Resonator) avec un capot intégré 70 en silicium monocristallin.

Il est également possible de combiner les différents modes proposés, par exemple le type de cavité (Si poreux ou SiGe/Si), l'existence ou non de la couche sacrificielle, la position de la couche sacrificielle avant le collage du second substrat (sur le premier substrat avec un collage normal sur le second substrat avec un collage "sur cavité" ou répartie sur les premier et deuxième substrats), la libération de la structure mécanique par gravure de la couche sacrificielle à travers les cavités ou via des ouvertures spécifiques, et/ou la gravure des zones localisées à travers les cavités ou à partir de la couche sacrificielle.

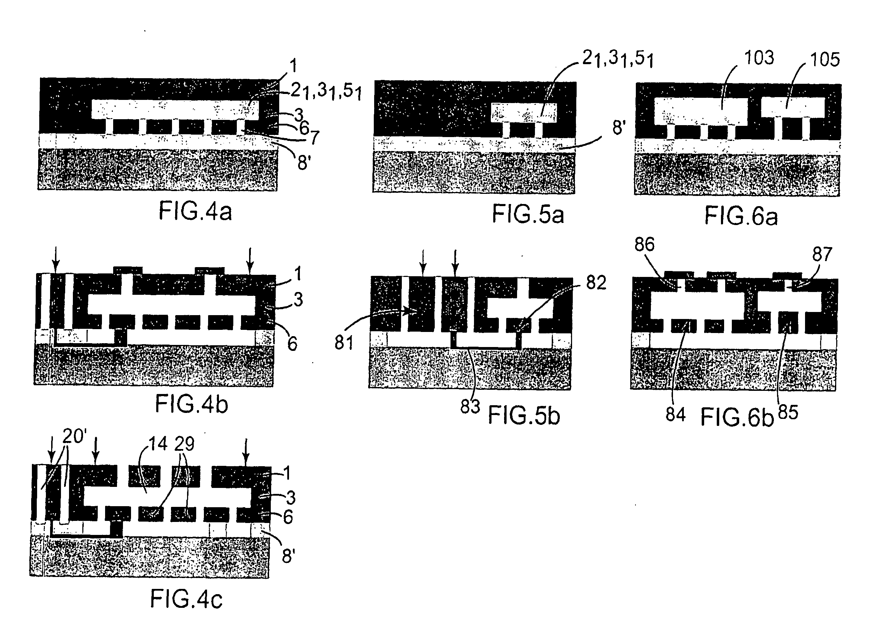

Les figures 4 à 9 illustrent la fabrication de 6 structures utilisant le principe de cavités enterrées. Chaque figure comprend la description du substrat hétérogène associé après l'étape a du procédé puis en fin de procédé. Chaque structure décrite correspond à une géométrie différente de zones de gravure donnée permettant d'illustrer les types de fonctions pouvant être réalisées.

I - Substrat hétérogène (figures 4a à 4c) comportant une unique zone de gravure couvrant la quasi totalité du composant et des tranchées permettant de réaliser un capot intégré (première couche mécanique 1) et structure mécanique (deuxième couche mécanique 6). Cette géométrie correspond aux figures 1a à 1o. Cette configuration lorsqu'elle comprend un rebouchage des ouvertures peut être utilisée pour réaliser une structure inertielle avec un capot intégré. La première couche mécanique 1 peut être également utilisée pour réaliser des électrodes supérieures. Il est possible de combiner les deux fonctions (capot et électrodes) en utilisant un rebouchage isolant, par exemple en verre PSG. Les connexions électriques peuvent être réalisées à partir de la face supérieure du substrat, directement pour les électrodes ou le capot, à travers des piliers en silicium monocristallin et des interconnexions en silicium polycristallin dopé pour la partie mécanique. Ce type de connexion peut être utilisé dans les autres configurations également.

Il - Substrat hétérogène comportant une zone de gravure occupant partiellement l'espace du composant permettant de réaliser deux structures MEMS élastiques 81 et 82 d'épaisseurs différentes dont l'un s'étend jusqu'à la surface et dont l'autre est enterrée, la gravure de la géométrie de la structure épaisse 81 étant réalisée avant la libération des cavités (figures 5a et 5b). Les contacts vers la couche mécanique de plus faible épaisseur peuvent être réalisés à travers une couche d'interconnexion en silicium placée sous et à travers la couche sacrificielle.

III - Substrat hétérogène comportant deux zones enterrées 102 et 103 d'épaisseurs différentes placées l'une à coté de l'autre (figures 6a et 6b)et couvrant la quasi-totalité du composant et des tranchées 86 et 87permettant de réaliser un composant MEMS avec un capot intégré et deux épaisseurs pour la structure mécanique par exemple pour réaliser deux structures élastiques 84 et 85 d'épaisseurs différentes au sein d'un même accéléromètre ou bien pour deux accéléromètres sur le même composant (mesure de l'accélération dans le plan et hors du plan) ou pour réaliser des électrodes au dessus de la couche mécanique. Lorsque les zones de gravure sont réalisées à partir de trois couches SiGe/Si/SiGe, les gravures profondes des deux couches mécaniques peuvent être simultanées. Sinon il faut utiliser un film sec en débutant par la gravure dont la précision est la plus critique.

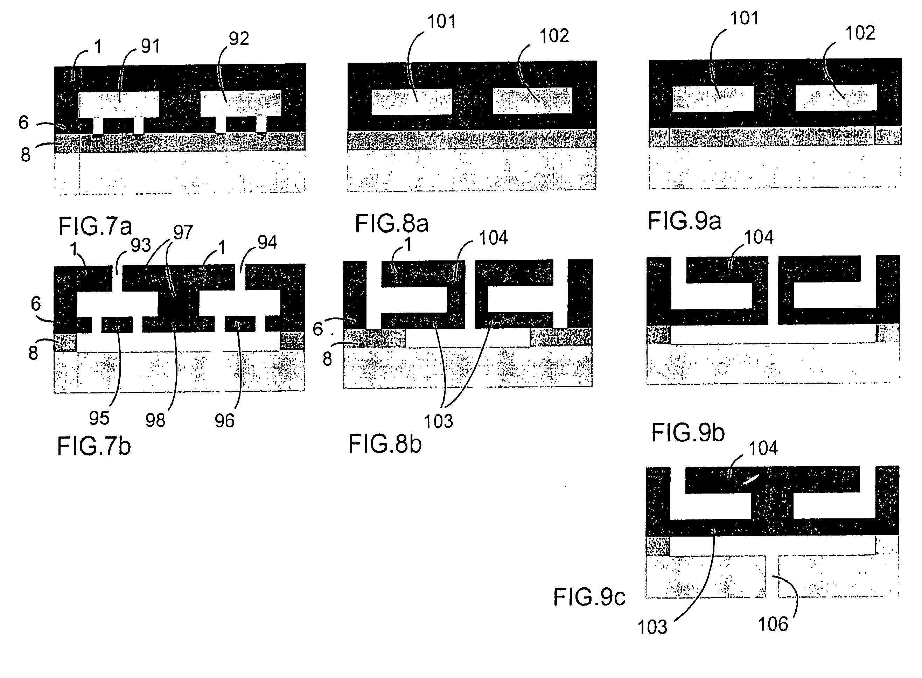

IV - Substrat hétérogène comportant deux zones de gravure 91 et 92 de même épaisseur et dans un même plan et des tranchées 93 et 94 permettant de réaliser un composant MEMS à deux régions superposées reliées entre elles mécaniquement (figures 7a et 7b). Cette configuration peut être utilisée pour la réalisation d'une masse 97 (première couche mécanique 1 épaisse) reliée rigidement par la région 97 à une structure mécanique 98 (deuxième couche mécanique 6 fine),

V - Substrat hétérogène comportant deux zones de gravure 101 et 102 de même épaisseur et dans le même plan, sans tranchées, permettant de réaliser une structure mécanique suspendue fine 103 associée à une masse 104 (figures 8a et 8b). La gravure de la couche sacrificielle se fait à partir d'ouvertures spécifiques.

VI - Substrat hétérogène identique au cas V mais avec soit collage sur cavité ne nécessitant pas de gravure de la couche sacrificielle après collage, soit libération de la structure mécanique par des ouvertures 106 réalisées à partir de la face arrière du composant (figures 9a et 9b).

## Revendications

1. Procédé de fabrication sur au moins un substrat d'un dispositif électromécanique comprenant au moins un élément actif, le procédé comportant:
a) la réalisation d'un substrat hétérogène comprenant une première partie (1, 3, 6), une couche d'interface (8) et une seconde partie (9), la première partie (1, 3, 6) comportant une ou plusieurs zones enterrées (2₁, 3₁, 5₁, 51) en sandwich entre une première (1), et une deuxième (6) région réalisées dans un premier matériau monocristallin, la première région (1) s'étendant jusqu'à la surface (1') de la première partie, et la deuxième région (6) s'étendant jusqu'à la couche d'interface (8, 8'), au moins une dite zone enterrée (2₁, 3₁, 5₁, 51) étant au moins en partie dans un deuxième matériau monocristallin de manière à la rendre sélectivement attaquable par rapport à la première (1) et la deuxième (6) région;
b) la réalisation depuis la surface (1") de la première partie et à travers ladite première région (1) d'ouvertures (20) débouchant sur au moins une dite zone enterrée (2₁, 3₁, 5₁, 5₁);
c) la gravure au moins partielle d'au moins une zone enterrée (2₁, 3₁, 5₁, 51) pour former au moins une cavité (14), la deuxième région présentant des zones localisées (7, 7') s'étendant entre au moins une couche enterrée (2₁, 3₁, 5₁, 51) et la couche d'interface (8) de manière à définir la géométrie d'au moins un élément actif qui est au moins une partie de la deuxième région (6) entre une dite cavité (14) et ladite couche d'interface (8, 8');
**caractérisé en ce que** les première (1, 3, 6) et seconde (9) parties du substrat sont constituées respectivement d'un premier et d'un deuxième substrats assemblés par collage dont l'un au moins porte au moins sur une partie de sa surface, une dite couche d'interface (8).

2. Procédé selon la revendication 1, **caractérisé en ce que** lesdites zones localisées sont des tranchées (7).

3. Procédé selon la revendication 1, **caractérisé en ce que** lesdites zones localisées sont pleines (7') et sont gravées après l'étape c de manière à former des tranchées (26).

4. Procédé selon la revendication 1, **caractérisé en ce que** les zones localisées sont pleines (7'), **en ce que** la couche d'interface comporte une couche sacrificielle en contact avec la deuxième région, **en ce qu'**il comporte la réalisation d'au moins une ouverture (80) débouchant sur ladite couche sacrificielle qui est réalisée à partir de la surface (6') de la première partie en dehors de la ou des zones enterrées (2₁, 3₁, 5₁, 51), jusqu'à atteindre la couche sacrificielle, l'enlèvement au moins partiel de la couche sacrificielle par gravure à travers au moins une dite ouverture (80) et la gravure des zones localisées (7) de manière à former des tranchées (26).

5. Procédé selon l'une des revendications précédentes, **caractérisé en ce que** la couche d'interface comprend une couche sacrificielle (8) en contact avec la deuxième région (6), et **en ce qu'**il comporte après l'étape c) une étape d'enlèvement au moins partiel de ladite couche sacrificielle (8) au moins au voisinage d'un dit élément actif.

6. Procédé selon la revendication 5, **caractérisé en ce que** la couche sacrificielle est enlevée au moins partiellement par gravure à travers d'une part lesdites ouvertures (20) ménagées à l'étape c, d'autre part au moins une dite cavité (14) et enfin de tranchées ménagées dans la deuxième région.

7. Procédé de fabrication d'un selon une des revendications 5 ou 6, **caractérisé en ce que** préalablement audit enlèvement de la couche sacrificielle (8), au moins une ouverture (8) débouchant sur ladite couche sacrificielle (8) est réalisée dans la première partie en dehors de la ou des zones enterrées (2₁, 3₁, 5₁, 5₁).

8. Procédé selon la revendication 1 **caractérisé en ce que** la réalisation de la première partie du substrat hétérogène comporte à partir d'un support (1) en ledit premier matériau monocristallin :
a₀) la formation d'au moins une zone enterrée par :
- épitaxie sur ledit support, d'une première couche (2₁) de SiGe monocristallin,
- épitaxie d'une couche (3₁) de Si monocristallin,
- épitaxie d'une deuxième couche (5₁) de SiGe monocristallin, et
a₁) l'épitaxie d'au moins une couche (6) de matériau monocristallin, au moins sur la deuxième couche épitaxiée de SiGe pour former au moins une partie de l'élément actif.

9. Procédé selon la revendication 1 **caractérisé en ce que** la réalisation de la première partie du substrat hétérogène comporte à partir d'un support en silicium monocristallin:
a'0) la formation d'au moins une zone enterrée (51)par réalisation de silicium poreux dans au moins une partie dudit support et
a'1) l'épitaxie d'au moins une couche (52) de matériau monocristallin, au moins sur le silicium poreux pour former au moins une partie de l'élément actif.

10. Procédé selon l'une des revendications 8 ou 9 **caractérisé en ce** les zones localisées reliant au moins une zone enterrée à la couche d'interface sont réalisées par gravure de tranchées au moins dans la ou les couches épitaxiées à l'étape a₁ ou a'₁.

11. Procédé selon une des revendications 4 à 10, **caractérisé en ce que** la couche sacrificielle est en PSG ou en silice.

12. Procédé selon une des revendications précédentes **caractérisé en ce que** la couche d'interface comporte des connexions électriques du dispositif électromécanique.

13. Procédé selon une des revendications précédentes **caractérisé en ce que** le substrat comporte au moins deux zones enterrées (91, 92) d'épaisseurs égales juxtaposées.

14. Procédé selon une des revendications 1 à 12 **caractérisé en ce que** le substrat comporte au moins deux zones enterrées (103, 105) d'épaisseurs différentes juxtaposées.

15. Procédé selon une des revendications précédentes **caractérisé en ce que** le substrat comporte au moins deux zones enterrées superposées au moins partiellement.

## Claims

1. A method of fabricating an electromechanical device on at least one substrate, the device including at least one active element and the method comprising:
a) making a heterogeneous substrate comprising a first portion (1, 3, 6), an interface layer (8), and a second portion (9), the first portion (1, 3, 6) including one or more buried zones (2₁, 3₁, 5₁, 51) sandwiched between first and second regions (1, 6) formed in a first monocrystalline material, the first region (1) extending to the surface (1') of the first portion, and the second region (6) extending to the interface layer (8, 8'), at least one said buried zone (2₁, 3₁, 5₁, 51) being made at least in part out of a second monocrystalline material so as to make it selectively attackable relative to the first and second regions (1, 6);
b) making openings (20) from the surface (1") of the first portion and through the first region (1), which openings open out to at least one said buried zone (2₁, 3₁, 5₁, 51); and
c) etching at least part of at least one buried zone (2₁, 3₁, 5₁, 51) to form at least one cavity (14), the second region presenting localized zones (7, 7') extending between at least one buried layer (2₁, 3₁, 5₁, 51) and the interface layer (8) in such a manner as to define the shape of at least one active element that is at least a portion of the second region (6) between a said cavity (14) and said interface layer (8, 8');
the method being **characterized in that** the first and second portions (1, 3, 6; 9) of the substrate are constituted respectively from first and second substrates that are assembled together by bonding, at least one of them including at least one said interface layer (8) over at least a fraction of its surface.

2. A method according to claim 1, **characterized in that** said localized zones are trenches (7).

3. A method according to claim 1, **characterized in that** said localized zones (7') are solid and are etched after step c) so as to form trenches (26).

4. A method according to claim 1, **characterized in that** the localized zones (7') are solid, **in that** the interface layer includes a sacrificial layer in contact with the second region, and **in that** the method includes making at least one opening (80) opening out into said sacrificial layer, which opening is made from the surface (6') of the first portion outside the buried zones(s) (2₁, 3₁, 5₁, 51) until it reaches the sacrificial layer, with at least part of the sacrificial layer being removed by etching through at least one said opening (80) and with the localized zones (7) being etched in such a manner as to form trenches (26).

5. A method according to any preceding claim, **characterized in that** the interface layer includes a sacrificial layer (8) in contact with the second region (6), and **in that** the method includes, after step c), a step of removing at least part of said sacrificial layer (8) at least in the vicinity of a said active element.

6. A method according to claim 5, **characterized in that** the sacrificial layer is removed at least in part firstly by etching through said openings (20) made in step c), and secondly by etching at least one said cavity (14), and finally trenches formed in the second region.

7. A fabrication method according to claim 5 or claim 6, **characterized in that** prior to said removal of the sacrificial layer (8), at least one opening (80) opening out into said sacrificial layer (8) is made in the first portion outside the buried zone(s) (2₁, 3₁, 5₁, 51).

8. A method according to claim 1, **characterized in that** the first portion of the heterogeneous substrate is made by a method starting from a support (1) made of said first monocrystalline material, and comprising the following steps:
a₀) forming at least one buried zone by:
epitaxially growing a first layer (2₁) of monocrystalline SiGe on said support;
epitaxially growing a layer (3₁) of monocrystalline Si; and
epitaxially growing a second layer (5₁) of monocrystalline SiGe; and
a₁) epitaxially growing at least one layer (6) of monocrystalline material, at least on the second epitaxial layer of SiGe so as to form at least a portion of the active element.

9. A method according to claim 1, **characterized in that** the first portion of the heterogeneous substrate is made by a method starting from a monocrystalline silicon support and comprising the following steps:
a'0) forming at least one buried zone (51) by making porous silicon in at least a portion of said support; and
a'1) epitaxially growing at least one layer (52) of monocrystalline material, at least on the porous silicon so as to form at least a portion of the active element.

10. A method according to claim 8 or claim 9, **characterized in that** the localized zones connecting at least one buried zone to the interface layer are made by etching trenches at least in the layer(s) grown epitaxially in step a₁) or a'₁).

11. A method according to any one of claims 4 to 10, **characterized in that** the sacrificial layer is made of PSG or of silica.

12. A method according to any preceding claim, **characterized in that** the interface layer includes electrical connections for the electromechanical device.

13. A method according to any preceding claim, **characterized in that** the substrate includes at least two juxtaposed buried zones (91, 92) of equal thickness.

14. A method according to any one of claims 1 to 12, **characterized in that** the substrate includes at least two juxtaposed buried zones (103, 105) of different thicknesses.

15. A method according to any preceding claim, **characterized in that** the substrate includes at least two buried zones that are superposed, at least in part.

## Patentansprüche

1. Verfahren, um auf wenigstens einem Substrat eine elektromechanische Vorrichtung, die wenigstens ein aktives Element enthält, herzustellen, wobei das Verfahren umfasst:
a) Herstellen eines heterogenen Substrats, das einen ersten Teil (1, 3, 6), eine Grenzflächenschicht (8) und einen zweiten Teil (9) umfasst, wobei der erste Teil (1, 3, 6) eine oder mehrere vergrabene Zonen (2₁, 3₁, 5₁, 51) sandwichartig zwischen einem ersten Bereich (1) und einem zweiten Bereich (6), die in einem ersten monokristallinen Material verwirklicht sind, aufweist, wobei sich der erste Bereich (1) bis zu der Oberfläche (1') des ersten Teils erstreckt und wobei sich der zweite Bereich (6) bis zu der Grenzflächenschicht (8, 8') erstreckt, wobei sich wenigstens eine vergrabene Zone (2₁, 3₁, 5₁, 51) wenigstens teilweise in einem zweiten monokristallinen Material befindet, derart, dass sie in Bezug auf den ersten Bereich (1) und den zweiten Bereich (6) wahlweise angreifbar gemacht wird;
b) Herstellen von Öffnungen (20), die in wenigstens eine der vergrabenen Zonen (2₁, 3₁, 5₁, 51) münden, ausgehend von der Oberfläche (1") des ersten Teils und durch den ersten Bereich (1) hindurch;
c) wenigstens teilweises Ätzen wenigstens einer vergrabenen Zone (2₁, 3₁, 5₁, 51), um wenigstens einen Hohlraum (14) zu bilden, wobei der zweite Bereich räumlich begrenzte Zonen (7, 7') aufweist, die sich zwischen wenigstens einer vergrabenen Schicht (2₁, 3₁, 5₁, 51) und der Grenzflächenschicht (8) erstrecken, derart, dass die Geometrie wenigstens eines aktiven Elements definiert wird, das wenigstens ein Teil des zweiten Bereichs (6) zwischen einem solchen Hohlraum (14) und dieser Grenzflächenschicht (8, 8') ist;
**dadurch gekennzeichnet, dass** der erste (1, 3, 6) und der zweite (9) Teil des Substrats aus einem ersten beziehungweise einem zweiten Substrat gebildet sind, die durch Kleben zusammengefügt sind, von denen wenigstens eines auf wenigstens einem Teil seiner Oberfläche die Grenzflächenschicht (8) trägt.

2. Verfahren nach Anspruch 1, **dadurch gekennzeichnet, dass** die räumlich begrenzten Zonen Einschnitte (7) sind.

3. Verfahren nach Anspruch 1, **dadurch gekennzeichnet, dass** die räumlich begrenzten Zonen massiv (7') sind und nach dem Schritt c) geätzt werden, um die Einschnitte (26) zu bilden.

4. Verfahren nach Anspruch 1, **dadurch gekennzeichnet, dass** die räumlich begrenzten Zonen massiv (7') sind, dass die Grenzflächenschicht eine Opferschicht aufweist, die mit dem zweiten Bereich in Kontakt ist, und dass es das Herstellen wenigstens einer Öffnung (80), die in die Opferschicht mündet, ausgehend von der Oberfläche (6') des ersten Teils außerhalb der einen oder der mehreren vergrabenen Zonen (2₁, 3₁, 5₁, 51) und bis zum Erreichen der Opferschicht, das wenigstens teilweise Entfernen der Opferschicht durch Ätzen durch wenigstens eine dieser Öffnungen (80) und das Ätzen der räumlich begrenzten Zonen (7), derart, dass Einschnitte (26) gebildet werden, umfasst.

5. Verfahren nach einem der vorhergehenden Ansprüche, **dadurch gekennzeichnet, dass** die Grenzflächenschicht eine Opferschicht (8) aufweist, die mit dem zweiten Bereich (6) in Kontakt ist, und dass es nach dem Schritt c) einen Schritt des wenigstens teilweisen Entfernens der Opferschicht (8) wenigstens in der Umgebung eines aktiven Elements umfasst.

6. Verfahren nach Anspruch 5, **dadurch gekennzeichnet, dass** die Opferschicht wenigstens teilweise durch Ätzen einerseits durch die im Schritt c) ausgesparten Öffnungen (20) und andererseits durch wenigstens einen Hohlraum (14) und schließlich durch Einschnitte, die in dem zweiten Bereich ausgebildet sind, entfernt wird.

7. Herstellungsverfahren nach einem der Ansprüche 5 oder 6, **dadurch gekennzeichnet, dass** vor dem Entfernen der Opferschicht (8) wenigstens eine Öffnung (8), die in die Opferschicht (8) mündet, in dem ersten Teil außerhalb der einen oder der mehreren vergrabenen Zonen (2₁, 3₁, 5₁, 51) hergestellt wird.

8. Verfahren nach Anspruch 1, **dadurch gekennzeichnet, dass** das Herstellen des ersten Teils des heterogenen Substrats ausgehend von einem Träger (1) aus dem ersten monokristallinen Substrat umfasst:
a₀) Bilden wenigstens einer vergrabenen Zone durch
- Epitaxie einer ersten Schicht (2₁) aus monokristallinem SiGe auf dem Träger,
- Epitaxie einer Schicht (3₁) aus monokristallinem Si,
- Epitaxie einer zweiten Schicht (5₁) aus monokristallinem SiGe, und
a₁) Epitaxie wenigstens einer Schicht (6) aus monokristallinem Material wenigstens auf der zweiten epitaktischen Schicht aus SiGe, um wenigstens einen Teil des aktiven Elements zu bilden.

9. Verfahren nach Anspruch 1, **dadurch gekennzeichnet, dass** das Herstellen des ersten Teils des heterogenen Substrats ausgehend von einem Träger aus monokristallinem Silizium umfasst:
a'0) Bilden wenigstens einer vergrabenen Zone (51) durch Herstellen von porösem Silizium wenigstens in einem Teil des Trägers und
a'1) Epitaxie wenigstens einer Schicht (52) aus monokristallinem Material wenigstens auf dem porösen Silizium, um wenigstens einen Teil des aktiven Elements zu bilden.

10. Verfahren einem der Ansprüche 8 oder 9, **dadurch gekennzeichnet, dass** die räumlich begrenzten Zonen, die wenigstens eine vergrabene Zone mit der Grenzflächenschicht verbinden, durch Ätzen von Scheiben wenigstens in der oder den epitaktischen Schichten des Schrittes a₁) oder a'₁) ausgebildet werden.

11. Verfahren nach einem der Ansprüche 4 bis 10, **dadurch gekennzeichnet, dass** die Opferschicht aus PSG oder aus Siliziumoxid besteht.

12. Verfahren nach einem der vorhergehenden Ansprüche, **dadurch gekennzeichnet, dass** die Grenzflächenschicht elektrische Verbindungen der elektromechanischen Vorrichtung enthält.

13. Verfahren nach einem der vorhergehenden Ansprüche, **dadurch gekennzeichnet, dass** das Substrat wenigstens zwei nebeneinander liegende vergrabene Zonen (91, 92) mit gleichen Dicken enthält.

14. Verfahren nach einem der Ansprüche 1 bis 12, **dadurch gekennzeichnet, dass** das Substrat wenigstens zwei nebeneinander liegende vergrabene Zonen (103, 105) mit unterschiedlichen Dicken enthält.

15. Verfahren nach einem der vorhergehenden Ansprüche, **dadurch gekennzeichnet, dass** das Substrat wenigstens zwei vergrabene Zonen enthält, die wenigstens teilweise übereinander liegen.
